Europäisches Patentamt

European Patent Office

Office européen des brevets

(11) Publication number: **0 218 402**
**A2**

# EUROPEAN PATENT APPLICATION

(21) Application number: **86307229.4**

(22) Date of filing: **19.09.86**

(51) Int. Cl.⁴: **H 03 K 5/13**
**H 03 L 7/00, H 04 N 1/21**

(30) Priority: **01.10.85 JP 218230/85**

(43) Date of publication of application:
**15.04.87 Bulletin 87/16**

(84) Designated Contracting States: **DE FR GB**

(71) Applicant: **SEIKO INSTRUMENTS & ELECTRONICS LTD.**
**31-1, Kameido 6-chome**
**Koto-ku Tokyo 136 (JP)**

(72) Inventor: **Tanaka, Fumihiro Seiko Instruments &**
**Electronics**
**31-1, Kameido 6-chome, Koto-ku**
**Tokyo (JP)**

**Matsushima, Kenichi Seiko Instruments & Electronic**
**31-1, Kameido 6-chome, Koto-ku**
**Tokyo (JP)**

**Shimada, Yoshio Seiko Instruments & Electronics**
**31-1, Kameido 6-chome, Koto-ku**
**Tokyo (JP)**

**Yamaguchi, Kaneo Seiko Instruments & Electronics**
**31-1, Kameido 6-chome, Koto-ku**
**Tokyo (JP)**

**Watanabe, Shinya Seiko Instruments & Electronics**
**31-1, Kameido 6-chome, Koto-ku**
**Tokyo (JP)**

(74) Representative: **Caro, William Egerton et al**
**J. MILLER & CO. Lincoln House 296-302 High Holborn**
**London WC1V 7JH (GB)**

(54) A sampling clock phase correction circuit.

(57) A sampling clock phase correction circuit (64) comprises a video signal sampling clock generation circuit (3,63) for producing a sampling clock (CK) having a constant phase relation with a reference input signal (STHD), a phase detection circuit (5) for detecting the phase of the sampling clock (CK) and the phase of a video sync signal (HD), and a CPU circuit (6) for receiving a detection signal (DT) from the phase detection circuit and discriminating advance and delay of phase of the sampling clock (CK) with respect to the phase of the video sync signal (HD). The arrangement is such that, in operation, the phase of the reference input signal (STHD) of the clock generation circuit is controlled with the detection signal (DT) so that the phase of the sampling clock (CK) is changed and the video sync signal (HD) is corrected.

FIG.1

FIG.2

EP 0 218 402 A2

# Description

## A SAMPLING CLOCK PHASE CORRECTION CIRCUIT

This invention relates to sampling clock phase correction circuits, for example, for use when a video signal from a video signal generation apparatus, such as a graphic display device, is sampled by an output device such as a hard copy device.

Output devices for conventional video signal generation apparatus deal only with those with low frequency video signals and strict phase correction, including temperature compensation, of a sampling clock phase has not been necessary. In addition, re-adjustment has not been necessary, either, once the phase relation between the video signal and the sampling clock has been made.

In graphic display devices used in recent CAD/CAM applications, a video frequency exceeding 100 MHz is used and in such an application, it is necessary to reproduce a picture with a high level of fidelity. At such a frequency range, however, a delay change quantity of circuit elements due to a temperature change, exerts significant influences and it is difficult even by use of a sampling clock generation circuit relying upon a high precision PLL circuit to keep phase drift below several nano-seconds. For this reason a correction circuit must be used for video signals above 100 MHz.

The present invention seeks to provide a sampling clock phase correction circuit which stably samples video signals in a high frequency range preventing change due to circuit elements altering their characteristics as a result of temperature.

According to one aspect of the present invention there is provided a sampling clock phase correction circuit characterised by comprising: a video signal sampling clock generation circuit for producing a sampling clock having a constant phase relation with a reference input signal; a phase detection circuit for detecting the phase of the sampling clock and the phase of a video sync signal; and a CPU circuit for receiving a detection signal from the phase detection circuit and discriminating advance and delay of phase of the sampling clock with respect to the phase of the video sync signal, the arrangement being such that, in operation, the phase of said reference input signal of said clock generation circuit is controlled in accordance with the detection signal of said CPU circuit so that the phase of said sampling clock is changed and the video sync signal is corrected.

Preferably a delay selector is provided to delay a horizontal sync signal of said video sync signal to produce the reference input signal.

In operation the phase delay of the sync signal is changed on the basis of the determination signal and phase correction is made so that the output of the detection circuit always keeps the same state. In this manner, the phase relation between the sync signal and the sampling clock can be directly kept constant while the phase relation between a video image signal which has a predetermined phase relation with the sync signal and the sampling clock can be indirectly kept constant.

The invention is illustrated, merely by way of example, in the accompanying drawings, in which:-

Figure 1 is a block diagram of a clock phase correction circuit according to the present invention;

Figure 2 is a circuit diagram of a phase detection circuit of the clock phase correction circuit of Figure 1;

Figure 3 is a signal timing chart to explain the operation of the clock phase correction circuits of Figures 1 and 2;

Figure 4 is a signal timing chart similar to Figure 3 illustrating the case where phase changes;

Figure 5 is an operational flow chart of a clock phase correction circuit according to the present invention; and

Figure 6 is a block diagram of a hard copy device with a clock phase correction circuit according to the present invention.

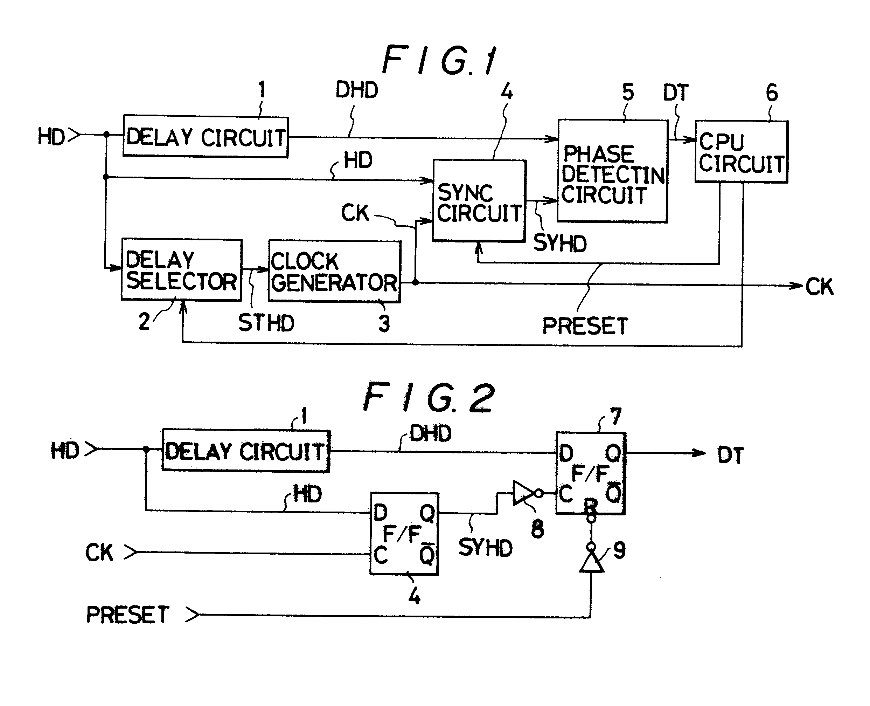

Figure 1 is a block diagram of a clock phase correction circuit according to the present invention. The clock phase correction circuit has a delay circuit 1 using, for example, a delay line. This delay circuit 1 outputs a signal DHD obtained by delaying a horizontal sync signal HD by about a half of a sampling clock CK. A delay selector uses, for example, a delay line and can arbitrarily select its delay in units of about 1 nsec. A clock generation circuit 3 generates the sampling clock CK on receipt of an output signal STHD of the delay selector 2. A sync circuit 4 samples the signal HD under the control of the sampling clock CK and generates a sampled horizontal sync signal SYHD which is in synchronism with the sampling clock CK. A phase detection circuit 5 compares the phase of the signal DHD with that of the signal SYHD and outputs "1" as a phase detection signal DT when the signal SYHD is ahead of the signal DHD and "0" when the former is behind the latter. A CPU circuit 6 controls the delay of the delay selector 2 in dependence upon detection signal DT.

Figure 2 illustrates the phase detecting circuit 5, the delay circuit 1 and the sync circuit 4 being shown also. A D-type flip-flop 7 detects the phase of the signal SYHD in accordance with that of the signal DHD. The signal DHD is inputted to a D terminal of the flip-flop 7 and the signal SYHD to a clock terminal C of the flip-flop through an inverter 8 and the signal DT is outputted from a Q terminal. Moreover, a preparatory signal for phase comparison (PRESET) is inputted to an R terminal through the inverter 9 from the CPU circuit 6.

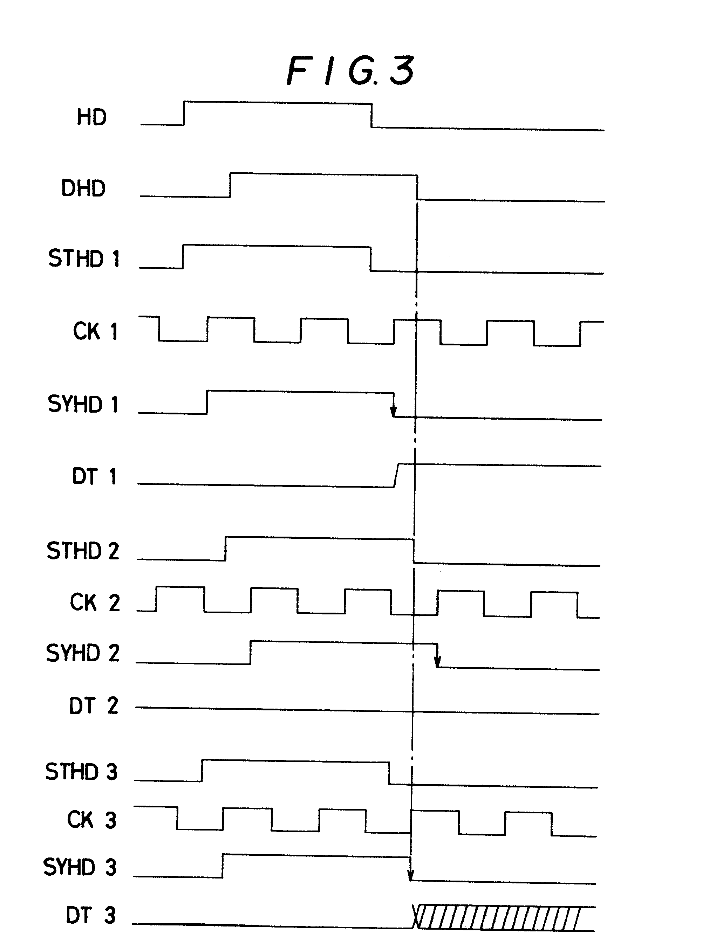

Figure 3 is a signal timing chart to show the operation of the sampling clock phase correction circuit of Figures 1 and 2. The signal DHD is later by a half period of the sampling clock CK than the signal HD. A signal STHD1 represents the state where the delay by the delay selector 2 is zero, and where the rise edge of a clock CK1 is later by 1/4 clock. A signal SYHD1 is generated by the signal HD and the clock CK1 and is later by 1/4 clock than the signal HD. As a result, the signal SYHD1 compared by the phase detection circuit 5 is ahead of the signal DHD so that "1" is outputted as a signal DT1.

Next, a signal STHD2 represents the case where the delay is 1/2 clock. In this case, a clock CK2 and a signal SYHD2 are later by 3/4 clock than the signal HD and the signal SYHD2 is behind the signal DHD so that "0" is outputted as a signal DT2.

Similarly, a signal STHD3 represents the case where the delay is 1/4 clock. The signal DHD and a signal SYHD3 have the same phase and the output signal DT3 is unstable. However, a clock CK3 for sampling the signal HD exhibits phase deviation of 1/2 clock with respect to the signal HD and hence sampling the signal HD can be made most stably.

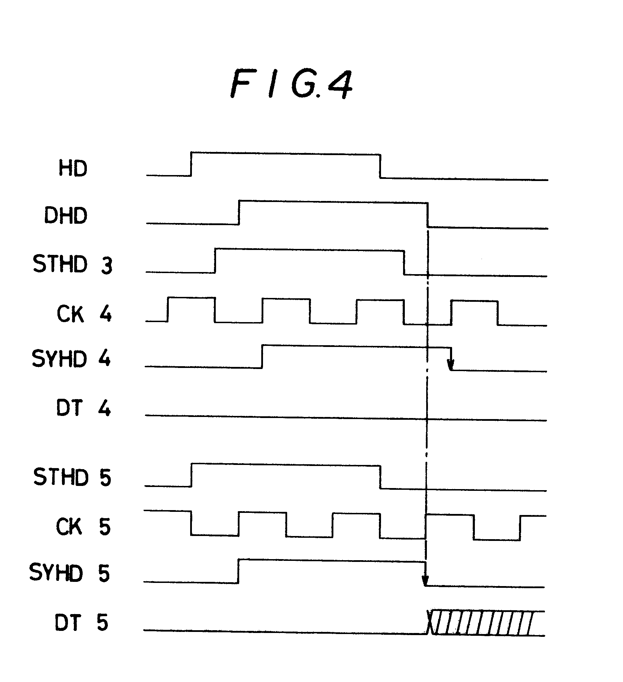

Next, the correction procedure when the phase of the sampling clock CK changes with respect to the signal STHD3 of Figure 3 will be explained with reference to Figure 4.

A clock CK4 exhibits phase deviation of 1/2 clock with respect to the signal STHD3. This shows that the delay of 1/4 clock occurs due to, for example, a temperature drift from the delay of 1/4 clock of the sampling clock CK with respect to the signal STHD shown in Figure 3. As a result, a signal SYHD4 is behind the signal DHD and a signal DT4 becomes "0". The CPU circuit 6 checks this state and changes the delay of the signal SYHD so as to attain the same state as that of the signal DT3 shown in Figure 3. This state is represented by a signal STHD5, a clock CK5 and a signal SYHD5, where the phase of the signal SYHD5 is coincident with that of the signal DHD so that the phase of the clock CK 5 is completely coincident with the phase of the clock CK3 shown in Figure 3.

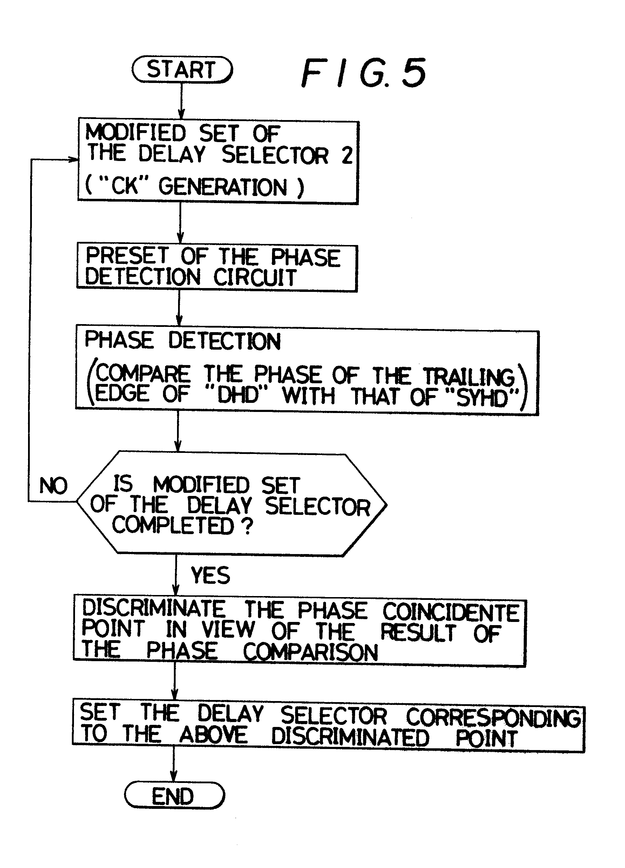

Figure 5 is an operational flow chart of the phase correction procedure mentioned above.

Accordingly, if the delay is controlled so that the signal DT is kept stable, the sampling clock CK can always keep the optimum phase relation with respect to the signal HD.

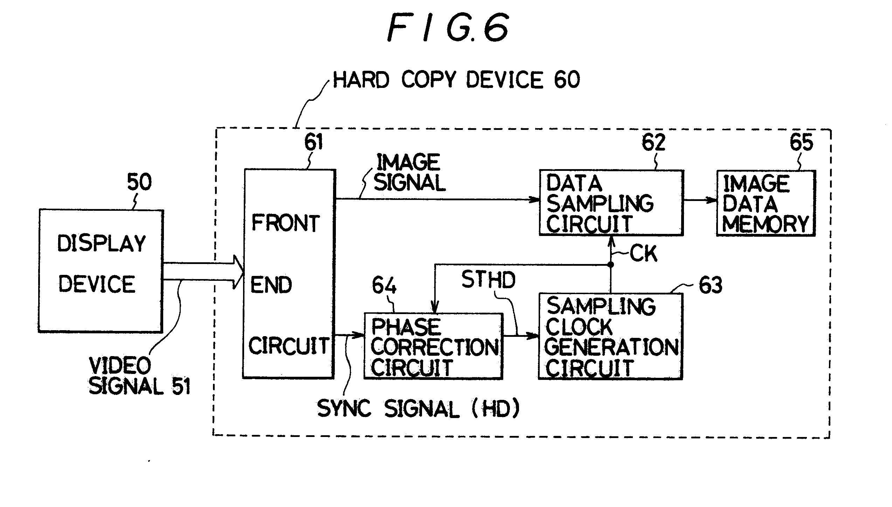

The above mentioned sampling clock phase dectection circuit according to the present invention is included in a hard copy device 60 as shown in Figure 6. A display device 50 produces a video signal 51 which is fed to a front end circuit 61 of the hard copy device 60. An image signal from the front end circuit is fed to a data sampling circuit 62 which provides an output to an image data memory 65. The front end circuit 61 also provides the sync signal HD to a phase correction circuit 64 which produces the signal STHD which is received by the sampling clock generator 63. The sampling clock generator circuit 63 produces the sampling clock to the data sampling circuit 62 and the phase correction circuit 64.

With the sampling clock phase correction circuit described above the phase of the input sync signal and that of the sampling clock and eventually, the phase relation between the video signal which has a predetermined phase relation with the sync signal and the sampling clock, can be always kept constant in a unit of adjustment of about 1nsec. Accordingly, video signals above 100 MHz can be sampled stably and a picture can be reproduced with high fidelity.

## Claims

1. A sampling clock phase correction circuit (64) characterised by comprising: a video signal sampling clock generation circuit (3,63) for producing a sampling clock (CK) having a constant phase relation with a reference input signal (STHD); a phase detection circuit (5) for detecting the phase of the sampling clock (CK) and the phase of a video sync signal (HD); and a CPU circuit (6) for receiving a detection signal (DT) from the phase detection circuit and discriminating advance and delay of phase of the sampling clock (CK) with respect to the phase of the video sync signal (HD), the arrangement being such that, in operation, the phase of said reference input signal (STHD) of said clock generation circuit (3,63) is controlled in accordance with the detection signal (DT) of said CPU circuit (6) so that the phase of said sampling clock (CK) is changed and the video sync signal (HD) is corrected.

2. A sampling clock phase correction circuit as claimed in claim 1 characterised in that a delay selector (2) is provided to delay a horizontal sync signal of said video sync signal (HD) to produce the reference input signal (STHD).

3. A hard copy device characterised by having a sampling clock phase correction circuit as claimed in claim 1 or 2.

4. In an output device such as a hard copy device (60) in a video signal generation apparatus such as a graphic display (50), a sampling clock phase correction circuit (64) of video signals (51) comprising: (a) a video signal sampling clock generation circuit (3,63) having a constant phase relation with a reference input signal (STHD); (b) a phase detection circuit (5) which comparatively detects a phase of a video signal sampling clock (CK) from said sampling clock generation circuit (3,63) and the phase of a video sync signal (HD); and (c) a CPU circuit (6) which receives the result of a detection (DT) and discriminates the advance and delay of the phase of the video signal sampling clock (CK) with respect to the phase of the video sync signal (HD); whereby the phase of said reference input signal (STHD) of said video signal sampling clock generation circuit (3,63) is controlled in accordance with the result of detection (DT) of said CPU circuit (6) so that the phase of said video signal sampling clock (CK) is changed and the phase of the video signal sampling clock (CK) with that of the video sync signal (HD) is corrected.

FIG.1

FIG.2

FIG. 3

0218402

FIG.4

# FIG. 5

```
( START )

┌─────────────────────────────┐
│ MODIFIED SET OF             │
│ THE DELAY SELECTOR 2        │
│ ("CK" GENERATION )          │
└─────────────────────────────┘
             │
             ▼
┌─────────────────────────────┐
│ PRESET OF THE PHASE         │
│ DETECTION CIRCUIT           │
└─────────────────────────────┘
             │
             ▼
┌─────────────────────────────────────────────┐
│ PHASE DETECTION                             │
│ ( COMPARE THE PHASE OF THE TRAILING )       │
│ ( EDGE OF "DHD" WITH THAT OF "SYHD" )       │
└─────────────────────────────────────────────┘
             │
             ▼
        IS MODIFIED SET
  NO   OF THE DELAY SELECTOR
        COMPLETED ?
             │
            YES
             │
             ▼
┌─────────────────────────────────────────────┐
│ DISCRIMINATE THE PHASE COINCIDENTE          │
│ POINT IN VIEW OF THE RESULT OF              │
│ THE PHASE COMPARISON                        │
└─────────────────────────────────────────────┘
             │
             ▼
┌─────────────────────────────────────────────┐
│ SET THE DELAY SELECTOR CORRESPONDING        │
│ TO THE ABOVE DISCRIMINATED POINT            │
└─────────────────────────────────────────────┘
             │
             ▼
         ( END )
```

## F I G. 6

HARD COPY DEVICE 60

DISPLAY DEVICE 50

VIDEO SIGNAL 51

FRONT END CIRCUIT 61

IMAGE SIGNAL

SYNC SIGNAL (HD)

64 PHASE CORRECTION CIRCUIT

STHD

63 SAMPLING CLOCK GENERATION CIRCUIT

CK

DATA SAMPLING CIRCUIT 62

IMAGE DATA MEMORY 65